# EUROPÄISCHE PATENTSCHRIFT

(11) **EP 2 659 505 B1**
(45) Veröffentlichungstag und Bekanntmachung des Hinweises auf die Patenterteilung: **09.04.2014**
(21) Anmeldenummer: 12714278.4
(22) Anmeldetag: 30.03.2012
(51) Int. Cl.: H01L 21/67

(54) **VERFAHREN UND VORRICHTUNG ZUM BONDEN ZWEIER WAFER**
APPARATUS AND METHOD FOR BONDING TWO WAFERS
APPAREIL ET PROCEDE POUR ATTACHER DEUX PLAQUETTES

(30) Priorität: 11.05.2011 AT 6662011
(43) Veröffentlichungstag der Anmeldung: 06.11.2013
(73) Patentinhaber: Thallner, Erich, 4782 St. Florian (AT)
(72) Erfinder: Thallner, Erich, 4782 St. Florian (AT)
(74) Vertreter: Schweiger, Johannes
(86) Internationale Anmeldenummer: PCT/EP2012/055840
(87) Internationale Veröffentlichungsnummer: WO 2012/152507

(56) Entgegenhaltungen:
- EP-A2- 0 926 706
- JP-A- 2000 188 245
- JP-A- 2010 245 396
- US-A- 5 769 991

## Beschreibung

Die vorliegende Erfindung betrifft eine Vorrichtung zum, insbesondere permanenten, Bonden zweier Wafer, insbesondere Strukturwafer, gemäß Patentanspruch 1 und ein korrespondierendes Verfahren gemäß Patentanspruch 9.

Das permanente Verbinden beziehungsweise Bonden von Strukturwafern erfolgt beispielsweise durch Diffusionsbonds, eutektische Bonds oder Glasfritbonds, wobei Cu-Cu-Verbindungen in den letzten Jahren für etliche Anwendungszwecke besonders bevorzugt waren.

Für das Verbinden sind hohe Temperaturen und/oder Drücke für einen stabilen, irreversiblen Bond erforderlich.

Bei in der Fläche immer größer und vom Durchmesser immer dünner werdenden Strukturwafern ergeben sich für Bondingverfahren immer größere Schwierigkeiten, zumal die Ausbeute an Chips möglich groß sein soll. Auf der anderen Seite besteht die Forderung einer kostengünstigen und schonenden Herstellung eines Permanentbonds an der Verbindungsfläche beziehungsweise Kontaktfläche zwischen den Wafern.

Die EP 0 926 706 A2 offenbart eine Substratverarbeitungsanlage, bei der Wafer durch einen Pin vorgebondet werden. Die JP 2010-245396 A betrifft ein Herstellungsverfahren und eine Laminiervorrichtung für Soi-Wafer. Die JP 2000-188245 A offenbart ein Verfahren zum Verbinden von Wafern und die US 5,769,991 A offenbart ein Verfahren und eine Vorrichtung zum Bonden von Wafern.

Es ist daher die Aufgabe der vorliegenden Erfindung, eine Vorrichtung und ein Verfahren zum Bonden von Wafern anzugeben, mit welchen eine schonende, effektive und kostengünstige Herstellung eines Bonds, insbesondere Permanentbonds, ermöglicht wird.

Diese Aufgabe wird mit den Merkmalen der Patentansprüche 1 und 9 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertbereichen sollen auch innerhalb der genannten Grenzen liegende Werte als Grenzwerte offenbart gelten und in Kombination beanspruchbar sein.

Der Grundgedanke der vorliegenden Erfindung besteht darin, Druckübertragungsmittel vorzusehen, mit welchen der Bonddruck nacheinander auf Teilabschnitte der Verbindungsfläche zwischen den beiden Wafern aufgebracht wird. Mit anderen Worten ist die Druckfläche zur Beaufschlagung der Wafer mit dem Bonddruck kleiner, insbesondere deutlich kleiner, als die Verbindungsfläche der beiden Wafer. Somit ist es erfindungsgemäß möglich, die insgesamt zu einer bestimmten Zeit aufzubringende Druckkraft zu reduzieren, wodurch einerseits das Material geschont wird und andererseits die Vorrichtungen wesentlich kostengünstiger herstellbar sind.

Insbesondere bei direkter Kontaktierung eines Wafers mit der Druckfläche wirkt sich die Erfindung derart aus, dass der konstruktive Aufwand für die Druckbeaufschlagung zum Verbinden der beiden Wafer deutlich reduziert wird. Dies gilt besonders für die Verwendung der vorliegenden Erfindung bei Wafergrößen ab 300 mm Durchmesser, noch bevorzugter mindestens 400 mm Durchmesser.

Erfindungsgemäß ist es daher vorgesehen, die Druckfläche systematisch und gleichmäßig relativ zur Verbindungsfläche der Wafer, also parallel zu der Verbindungsfläche, zu bewegen und die Verbindungsfläche gleichmäßig mit Druck zu beaufschlagen. Insbesondere ist die Summe der an der auf die Verbindungsfläche wirkenden Kräfte entlang der Oberfläche homogen verteilt. Mit anderen Worten: Die während der Druckbeaufschlagung der Verbindungsfläche der Wafer in jedem Punkt wirkende Summenkraft ist im Wesentlichen identisch, insbesondere mit einer Abweichung von weniger als 20 %, vorzugsweise weniger als 10 %.

Gemäß einer vorteilhaften Ausführungsform der Erfindung ist vorgesehen, dass die Druckfläche <80 %, insbesondere <60 %, vorzugsweise kleiner <40 % der Verbindungsfläche beträgt.

Soweit die Druckfläche zumindest teilweise, insbesondere vollständig, entlang einer von der Verbindungsfläche abgewandten Beaufschlagungsfläche eines der Wafer bewegbar ist, ist die Ausführung der Erfindung konstruktiv einfach zu lösen. Dabei ist es von Vorteil, wenn die Druckfläche nur einen der beiden Wafer beaufschlagt und der andere Wafer vollflächig mit seiner von der Verbindungsfläche abgewandten Auflagefläche auf einer Aufnahme, insbesondere einem Chuck, fixiert ist.

Weiterhin ist es erfindungsgemäß von Vorteil, wenn der Bonddruck auf einen zur Druckfläche korrespondierenden Teilabschnitt der Verbindungsfläche aufbringbar ist. Dies ist insbesondere dann der Fall, wenn die Druckfläche in direktem Kontakt mit dem Wafer ist und keine dazwischen liegenden Elemente oder Druckplatten oder Druckverteiler vorgesehen sind. Der Druck kann auf diese Weise direkt aufgebracht werden und homogen entlang der Verbindungsfläche beaufschlagt werden.

Indem die Druckfläche zumindest teilweise, insbesondere vollständig, mit Ultraschall beaufschlagbar ist, kann zusätzlich zu dem an der Druckfläche anliegenden Druck eine Schwingungsenergie an der Verbindungsfläche aufgebracht werden. Dies ist besonders dann von Vorteil, wenn entlang der Verbindungsfläche, also an den zu verbindenden Oberflächen der Wafer, eine Oxidschicht vorliegt. Die Einbringung von Ultraschallschwingungen wird besonders in Verbindung mit der vergleichsweise kleinen Druckfläche der erfindungsgemäß vergleichsweise kleinen Druckfläche vereinfacht, da die Ultraschallschwingungen bei der bezogen auf die kleinere Druckfläche entsprechend geringeren Kraft, insbesondere konstruktiv, einfacher aufbringbar sind. Die Konstruktion der erfindungsgemäßen Vorrichtung wird daher kostengünstiger und eine homogenere und schonende Druckbeaufschlagung und/oder Schwingungsbeaufschlagung der Verbindungsfläche wird hierdurch erst ermöglicht.

Gemäß einer weiteren vorteilhafteren Ausführungsform der Erfindung ist vorgesehen, dass die Druckfläche parallel zur Beaufschlagungsfläche, insbesondere linear oder rotatorisch, bewegbar ist. Entscheidend ist eine Relativbewegung zwischen der Druckfläche und der Beaufschlagungsfläche, so dass entweder die Druckübertragungsmittel durch entsprechende Antriebsmittel bewegt werden oder die Aufnahme des Wafers bewegt wird oder, was entsprechend aufwendiger wäre, sowohl die Antriebsmittel für die Druckübertragungsmittel als auch die Aufnahme bewegt werden.

Soweit die Druckfläche keilförmig ist, ergibt sich bei kreisförmig zu beaufschlagenden Wafern eine homogene Kraftverteilung entlang der Verbindungsfläche, insbesondere bei rotatorischer Beaufschlagung.

Soweit die Druckfläche streifenförmig ist, insbesondere mit parallelen Längsseiten, ergibt sich insbesondere bei quadratischen oder rechteckigen Waferflächen eine homogene Druckverteilung bei gleichem Kraftaufwand. Anderenfalls müsste durch entsprechende Steuerung die Kraftverteilung an die jeweils mit der Druckfläche in Kontakt stehende Beaufschlagungsfläche angepasst werden.

Die oben beschriebenen Vorrichtungsmerkmale beziehungsweise Verfahrensmerkmale gelten für das erfindungsgemäß beschriebene Verfahren und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a: eine Querschnittsansicht einer erfindungsgemäßen Vorrichtung in einer ersten Ausführungsform in einem ersten Verfahrensschritt in einer Seitenansicht,
- Fig. 1b: die Ausführungsform gemäß Figur 1a in einem zweiten Verfahrensschritt in einer Seitenansicht,
- Fig. 1c: die Ausführungsform gemäß Figuren 1a und 1b in einem dritten Verfahrensschritt in einer Aufsicht,
- Fig. 2: eine Aufsicht einer zweiten Ausführungsform der erfindungsgemäßen Erfindung,
- Fig. 3: eine Aufsicht einer dritten Ausführungsform der vorliegenden Erfindung und
- Fig. 4a: eine Aufsicht einer vierten Ausführungsform der Erfindung,
- Fig. 4b: eine Seitenansicht der Ausführungsform gemäß Figur 4a.

In den Figuren sind gleiche oder gleich wirkende Merkmale mit den gleichen Bezugszeichen gekennzeichnet.

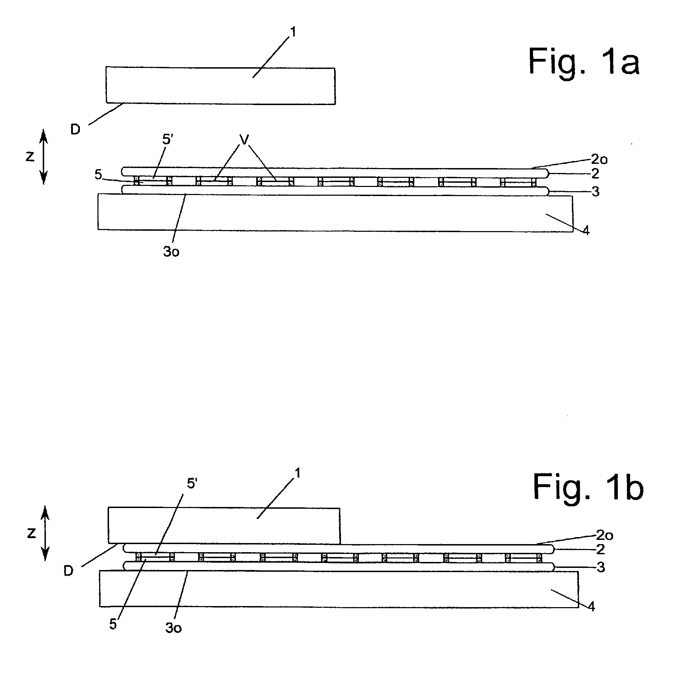

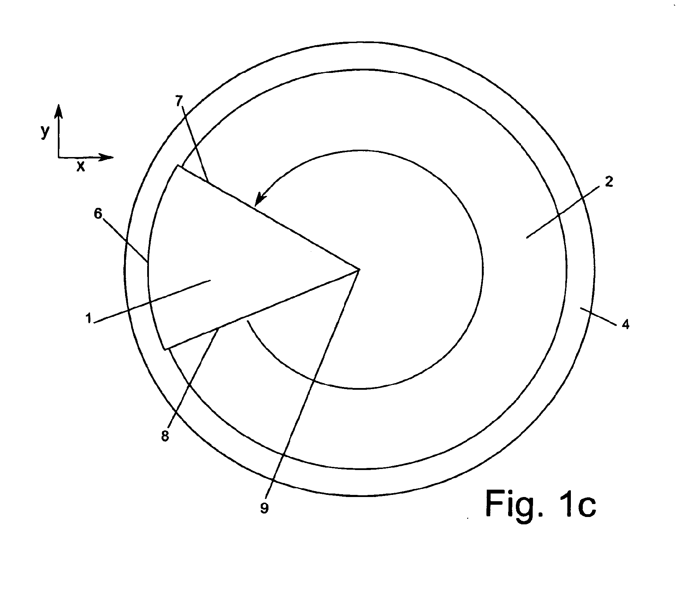

In Figur 1 ist die erfindungsgemäße Vorrichtung stark schematisiert dargestellt, nämlich eine als Probenhalter dienende Aufnahme 4, die insbesondere als Chuck mit nicht dargestellten Vakuumbahnen zur Fixierung eines Strukturwafers 3 ausgestattet ist.

Der Strukturwafer 3 wird mit seiner Aufnahmefläche 3o vollflächig auf der Aufnahme 4 abgelegt und gegebenenfalls dort fixiert.

Die Aufnahme 4 befindet sich dabei in einer, insbesondere mit Vakuum beaufschlagbaren, Bondkammer, die als bekannt vorausgesetzt wird und daher nicht im Einzelnen dargestellt ist.

Der erste Strukturwafer 3 weist zumindest an seiner zur Aufnahmefläche 3o abgewandten Seite Strukturen 5, insbesondere elektronische Bauteile, auf.

Auf den ersten Strukturwafer 3 beziehungsweise die auf dem Strukturwafer 3 befindlichen Strukturen 5 wird ein zweiter Strukturwafer 2 (gegebenenfalls mit korrespondierenden Strukturen 5') auf den ersten Strukturwafer 3 abgelegt beziehungsweise mit diesem kontaktiert. In einem vorherigen Schritt werden die Strukturwafer 2, 3 zueinander ausgerichtet, wofür entsprechende Ausrichtungsmittel (nicht dargestellt) vorgesehen sind.

Zwischen den beiden Strukturwafern 2, 3 (genauer: zwischen den Strukturen 5, 5' der Strukturwafer 2, 3) entsteht durch die Kontaktierung eine Verbindungsfläche V, an der die beiden Strukturwafer 2, 3 miteinander verbunden werden beziehungsweise an der die Bondkraft am Ende des erfindungsgemäßen Verfahrens nach dem Verbinden der beiden Wafer 2, 3 vorherrschen soll. Die Verbindungsfläche V ist im Regelfall unwesentlich kleiner als die jeweilige Oberfläche der Strukturwafer 2, 3 an der Seite der Strukturen 5, 5', da die Strukturen 5, 5' möglichst eng (vollflächig) auf der jeweiligen Oberfläche der Strukturwafer 2, 3 aufgebracht werden, um die Ausbeute zu erhöhen. Insofern ist die Darstellung in den Figuren stark schematisiert und die Zwischenräume zwischen den Strukturen 5, 5' sind in der Realität wesentlich kleiner.

In der Bondkammer sind die Strukturwafer 2, 3 nicht nur mit einer Temperatur beaufschlagbar, sondern zusätzlich mit einem Druck, indem eine Druckplatte 1 als Bestandteil von Druckübertragungsmitteln in die in Figur 1b gezeigte Position abgesenkt wird, wobei eine der Aufnahme 4 zugewandte beziehungsweise den Strukturwafern 2, 3 zugewandte Druckfläche D auf die Beaufschlagungsfläche 2o des zweiten Strukturwafers 2 abgesenkt wird. Die Druckfläche D wird parallel zu der Beaufschlagungsfläche 2o ausgerichtet.

In Figur 1c ist in der Aufsicht erkennbar, dass mit der Druckplatte 1 nur ein Teilabschnitt der Beaufschlagungsfläche 2o gleichzeitig beaufschlagbar ist, da die Druckfläche D der Druckplatte 1 deutlich kleiner als die Beaufschlagungsfläche 2o ist. Die Druckplatte 1 ist über entsprechende, nicht dargestellte Antriebsmittel einerseits in einer Z-Richtung orthogonal zu der Verbindungsfläche beziehungsweise der Beaufschlagungsfläche bewegbar. In Figur 1c ist zu erkennen, dass zusätzlich eine Bewegung parallel zur Beaufschlagungsfläche 2o beziehungsweise zur Auflagefläche der Aufnahme 4, also in einer X-Y-Ebene, durch entsprechende X-Y-Antriebsmittel ausführbar ist.

Im Falle der in Figur 1c gezeigten Ausführungsform wird die Druckplatte 1 rotiert, wobei die Beaufschlagungsfläche 2o von der Druckfläche D mit einem von einer Steuereinrichtung gesteuerten Druck beaufschlagt wird. Der Druck ist durch Kraftmessmittel messbar.

Die Druckplatte 1 beziehungsweise die Druckfläche D ist begrenzt durch zwei radial verlaufende Seiten 7, 8 und eine gebogene Seite 6. Die gebogene Seite 6 ist insbesondere konzentrisch zu einem Schnittpunkt 9 der Seiten 7, 8. Der Schnittpunkt 9 bildet gleichzeitig eine Spitze der Druckplatte 1, die zentrisch zu den Strukturwafern 2, 3 ausrichtbar ist. Gleichzeitig ist die Seite 6 konzentrisch zu den Strukturwafern 2, 3 ausgebildet und anordenbar und eine konzentrisch zu den Strukturwafern 2, 3 verlaufende Rotation der Druckplatte 1 ausführbar. Somit ist die Beaufschlagungsfläche 2o durch die Druckplatte 1 homogen mit einem Druck beaufschlagbar, wobei die Druckbeaufschlagung und Rotationsbewegung der Druckplatte 1 so gesteuert werden, dass an der Verbindungsfläche V in jedem Punkt der Verbindungsfläche V am Ende im Wesentlichen die gleiche Kraft gewirkt hat. Somit wird ein gleichmäßiger Bond entlang der Verbindungsfläche erreicht.

Durch die vergleichsweise kleine Druckplatte 1 beziehungsweise Druckfläche D wird es ermöglicht, zusätzlich zu der Druckkraft Schallwellen, insbesondere durch Beaufschlagung der Druckplatte 1, an der Verbindungsfläche V einzubringen. Vorzugsweise werden Ultraschallwellen verwendet, die die Funktion haben, etwaige Oxidschichten zu brechen und die Annäherung von Oberflächenrauhigkeiten, also Erhebungen und Vertiefungen, zu beschleunigen oder zu begünstigen. In Kombination mit einer Temperaturbeaufschlagung findet auch eine plastische Verformung entlang der Oberflächenrauhigkeiten an der Verbindungsfläche V der sich gegenüberliegenden Strukturen 5, 5' statt, insbesondere durch mittels der Schallwellen induzierte Scherspannungen.

Durch die Rotation der Druckplatte 1 wirkt jeweils in dem darunter liegenden Teilabschnitt der Beaufschlagungsfläche 2o und damit in dem darunter liegenden Teilabschnitt der Verbindungsfläche V ein Druck, insbesondere in Kombination mit den Schallwellen eines an der Druckplatte 1 vorgesehenen Schallgebers (nicht dargestellt). Der Druck in der Verbindungsfläche V wird durch die Rotation kontinuierlich auf die gesamte Verbindungsfläche V verteilt.

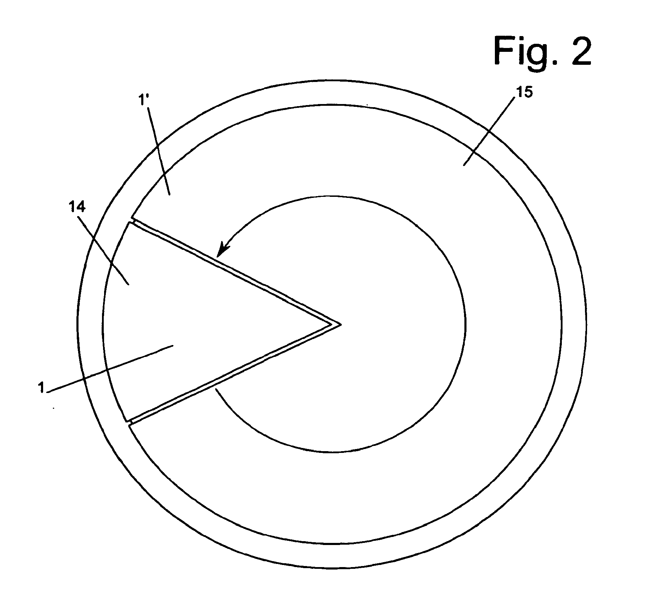

In der in Figur 2 gezeigten Ausführungsform ist zusätzlich zu der Druckplatte 1 eine die von der Druckplatte 1 nicht beaufschlagte Beaufschlagungsfläche 2o beaufschlagende zweite Druckplatte 15 vorgesehen. Die zweite Druckplatte 15 ist von der Druckplatte 1, insbesondere äquidistant, beabstandet und, insbesondere durch eigene Antriebsmittel, vorzugsweise unabhängig, von der Druckplatte 1, insbesondere synchron zur Druckplatte 1, rotierbar. Somit ist im Bereich der Druckplatte 1 eine Druckbeaufschlagung mit gleichzeitiger Schallbeaufschlagung und im Bereich der zweiten Druckplatte 15 eine Druckbeaufschlagung (insbesondere mit gleichem Druck wie bei der Druckplatte 1) erfindungsgemäß möglich, wobei die zweite Druckplatte 15 vorzugsweise nicht mit Schallwellen beaufschlagt wird.

Eine Relativverschiebung der Strukturwafer 2, 3 zueinander wird vermieden, indem ein ausreichend starker Prebond vor einer Bewegung der Druckübertragungsmittel in X-Y-Ebene stattfindet. Dies kann beispielsweise durch Druckbeaufschlagung über einen bestimmten Zeitraum und/oder Temperaturbeaufschlagung über einen bestimmten Zeitraum und/oder durch Fixierung der Strukturwafer 2, 3 relativ zueinander, insbesondere im Bereich des Umfangs der Strukturwafer 2, 3, erfolgen.

Durch die in Figur 2 dargestellte Ausführungsform wird somit eine fast vollflächige Beaufschlagung der Beaufschlagungsfläche 2o mit einer homogenen Druckkraft ermöglicht, wobei im Bereicht der Druckplatte 1 zusätzlich Schwingungen eingebracht werden können.

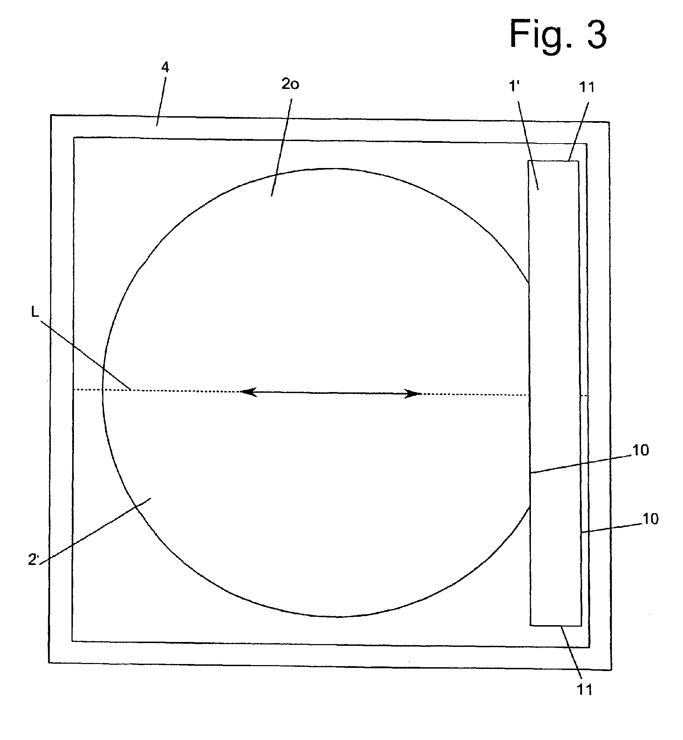

In der in Figur 3 gezeigten Ausführungsform erfolgt die Druckbeaufschlagung durch Linearbewegung entlang einer Linearrichtung L, wobei eine Druckplatte 1' mit einer streifenförmigen Druckfläche D vorgesehen ist. Die Druckfläche D weist zwei parallele Längsseiten 10 und zwei die parallelen Längsseiten 10 verbindende Seiten 11 auf. Die Druckplatte 1' ist so anordenbar, dass die Längsseiten 10 orthogonal zur Linearrichtung 11 ausgerichtet sind.

Die Beaufschlagungsfläche 2o des zweiten Strukturwafers 2 wird durch Linearbewegung und gleichzeitige Druckbeaufschlagung (und insbesondere zusätzlicher Beaufschlagung mit Schallwellen) kontinuierlich gebondet, wobei im Übrigen die Ausführungen zu Figur 1 zu den Figuren 1a bis 1c analog gelten.

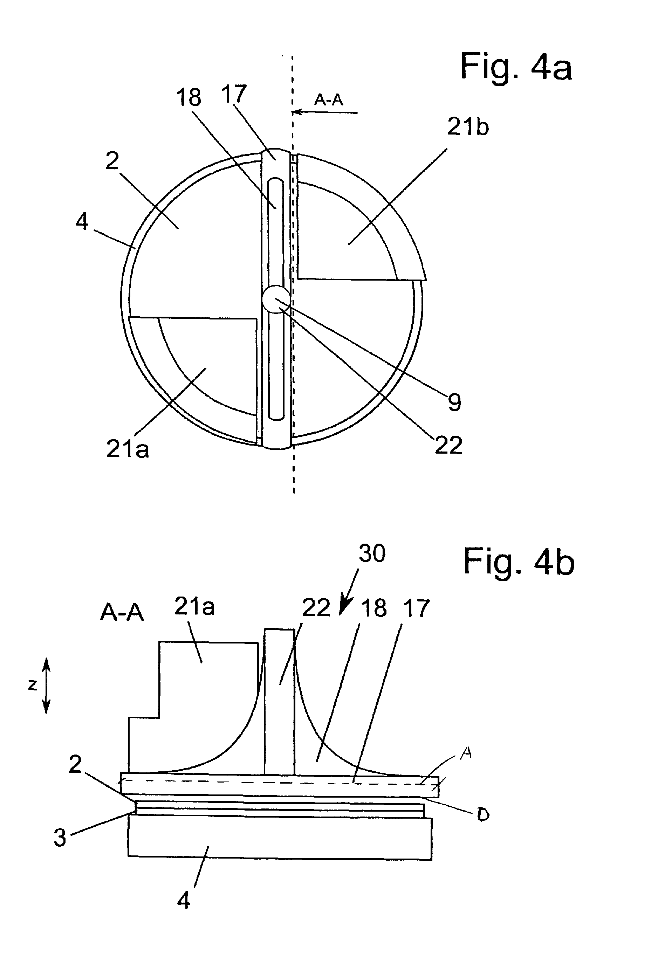

Die in Figur 4a und 4b dargestellte Ausführungsform stellt quasi eine Kombination der drei Ausführungsformen gemäß Figuren 1a, 1b, 1c, 2 und 3 dar.

Die Figuren 4a und 4b zeigen ein Werkzeug 30 als Bestandteil der Druckübertragungsmittel, bestehend aus einem konusförmig zu einer Druckfläche D zulaufenden Druckelement 17, einem das Druckelement 17 beaufschlagenden Schaft 22 und Stützstreben 18.

Das Werkzeug 30 kann, insbesondere in z-Richtung, schwingen oder vibrieren. Die Druckfläche D ist in einer Längsrichtung A mindestens so lang wie der Durchmesser des zu beaufschlagenden zweiten Strukturwafers 2, insbesondere mindestens 300mm (Länge). Quer zur Längsrichtung A, also in Querrichtung Q ist die Druckfläche D des Druckelements 17 dagegen sehr dünn, insbesondere kleiner als 10mm, vorzugsweise kleiner als 5mm, noch bevorzugter kleiner als 1mm (Breite). Die jeweils gegenüberliegenden Seiten der Druckfläche verlaufen analog der Ausführungsform gemäß Figur 3 parallel. Das Verhältnis zwischen Breite und Länge ist kleiner 1/30, insbesondere kleiner 1/50, noch bevorzugter kleiner 1/100.

Das Druckelement 17 ist um den Schaft 22, insbesondere hin und her, rotierbar, wobei Rotationsantriebsmittel nicht dargestellt sind. Die Rotation erfolgt um einen Drehpunkt 9, insbesondere konzentrisch zum Strukturwafer 2 beziehungsweise zur Aufnahme 4, entsprechende Ausrichtung der Strukturwafer 2, 3 vorausgesetzt.

Stempel 21 a und 21 b fixieren durch eine statische Druckkraft die Wafer 2 und 3, damit während der Rotation des Druckelements 17 eine Verschiebung der Wafer 2, 3 zueinander verhindert wird.

Das Druckelement 17 kontaktiert die Oberfläche 2o des Wafers 2. Mit Vorzug wird eine schwingende und oder vibrierende Bewegung dem statischen Druck überlagert. Danach beginnt sich das Druckelement 17 um den Drehpunkt 9 zu drehen. Die Stempel 21a und 21b beschränken dabei den Winkelbereich der Rotation auf 90°, wobei die Rotation in diesem Winkelbereich mehrfach wiederholt werden kann. Während einer 90° Drehbewegung werden etwa 50% der Fläche der beiden Wafer miteinander gebonded. Danach werden die Stempel 21a und 21b von der Beaufschlagungsfläche 2o abgehoben, so dass diese entlastet ist. Es folgt eine 90° Drehung der beiden Stempel 21a und 21b um den Drehpunkt 9. Die Stempel 21 a und 21 b werden danach wieder auf die Beaufschlagungsfläche 2o des zweiten Wafers 2 gedrückt und fixieren diesen. Schließlich erfolgt eine weitere durch statischen Druck und/oder Schwingung und/oder Vibration überlagerte 90°-Drehbewegung des Werkzeuges um den Drehpunkt 9, um die verbleibenden 50% der Waferoberflächen miteinander zu verbonden. Dieser Vorgang kann mehrmals wiederholt werden.

Die Druckflächen 1, 1' können mit Mustern strukturiert sein. Mit Vorzug sind die Muster regelmäßig.

### Bezugszeichenliste

- 1, 1': Druckplatte
- 2, 2': Zweiter Strukturwafer
- 2o, 2o': Beaufschlagungsfläche
- 3: Erster Strukturwafer
- 3o: Aufnahmeseite
- 4: Aufnahme
- 5, 5': Strukturen
- 6: Seite
- 7: Seite
- 8: Seite
- 9: Schnittpunkt
- 10: Längsseiten
- 11: Seiten
- 15: Zweite Druckplatte
- V: Verbindungsfläche
- D: Druckfläche
- L: Linearrichtung

## Patentansprüche

1. Vorrichtung zum Bonden zweier Wafer (2, 3) an einer Verbindungsfläche V der Wafer (2,3) wobei ein Druckübertragungsmittel mit einer Druckfläche D zur Beaufschlagung der Wafer (2, 3) mit einem Bonddruck an der Druckfläche D vorgesehen ist, und wobei die Druckfläche D kleiner als die Verbindungsfläche V ist, **dadurch gekennzeichnet, dass** der Bonddruck nacheinander mit dem Druckübertragungsmittel auf Teilabschnitte der Verbindungsfläche V aufbringbar ist.

2. Vorrichtung nach Anspruch 1, bei der die Druckfläche D<80 %, insbesondere <60 %, vorzugsweise <40 % der Verbindungsfläche V ist.

3. Vorrichtung nach einem der vorherigen Ansprüche, bei der die Druckfläche D zumindest teilweise, insbesondere vollständig, entlang einer von der Verbindungsfläche V abgewandten Beaufschlagungsfläche (2o, 2o') eines der Wafer (2, 3) bewegbar ist.

4. Vorrichtung nach einem der vorhergehenden Ansprüche, bei der der Bonddruck auf einen zur Druckfläche D korrespondierenden Teilabschnitt der Verbindungsfläche V aufbringbar ist.

5. Vorrichtung nach einem der vorhergehenden Ansprüche, bei die die Druckfläche zumindest teilweise, insbesondere vollständig mit Ultraschall beaufschlagbar ist.

6. Vorrichtung nach einem der vorhergehenden Ansprüche, bei der die Druckfläche D parallel zur Beaufschlagungsfläche (2o, 2o'), insbesondere linear oder rotatorisch bewegbar ist.

7. Vorrichtung nach einem der vorhergehenden Ansprüche, bei der die Druckfläche D keilförmig ausgebildet ist.

8. Vorrichtung nach einem der Ansprüche 1 bis 6, bei der die Druckfläche D streifenförmig, insbesondere mit parallelen Längsseiten (10), ist.

9. Verfahren zum Bonden zweier Wafer (2, 3) an einer Verbindungsfläche V der beiden Wafer (2, 3), wobei durch ein Druckübertragungsmittel (1) mit einer Druckfläche D zur Beaufschlagung der Wafer (2, 3) ein Bonddruck nacheinander auf Teilabschnitte der Verbindungsfläche V aufgebracht wird.

## Claims

1. A device for bonding of two wafers (2, 3) on one joining surface V of the wafers (2, 3), there being a pressure transfer means with a pressure surface D for applying a bond pressure to the wafers (2, 3) on the pressure surface D, and wherein the pressure surface D is smaller than the joining surface V, **characterized in that** the bonding pressure is applied with the pressure transfer means to partial portions of the joining surface V.

2. The device as claimed in Claim 1, wherein the pressure surface D is < 80%, especially < 60%, preferably <40% of the joining surface V.

3. The device as claimed in one of the preceding claims, wherein the pressure surface D can be moved at least partially, especially completely, along one action surface (2o, 2o') of one of the wafers (2, 3) facing away from the joining surface V.

4. The device as claimed in one of the preceding claims, wherein the bond pressure can be applied to a partial section of the joining surface V, which section corresponds to the pressure surface D.

5. The device as claimed in one of the preceding claims, wherein the pressure surface can be exposed at least partially, especially completely to ultrasound.

6. The device as claimed in one of the preceding claims, wherein the pressure surface D can be moved especially linearly or rotationally parallel to the action surface (2o, 2o').

7. The device as claimed in one of the preceding claims, wherein the pressure surface D is made wedge-shaped.

8. The device as claimed in one of Claims 1 to 6, wherein the pressure surface D is strip-shaped, especially with parallel longitudinal sides (10).

9. A method for bonding of two wafers (2, 3) on one joining surface V of the two wafers (2, 3), wherein by a pressure transfer means (1) with a pressure surface D for acting on the wafers (2, 3) a bond pressure being applied in succession to partial sections of the joining surface V.

## Revendications

1. Procédé destiné à faire adhérer deux tranches (2, 3) sur une surface de liaison V des tranches (2, 3), dans lequel un moyen de transmission de pression avec une surface de pression D est prévu pour appliquer une pression d'adhérence sur les tranches (2, 3) sur la surface de pression D, et dans lequel la surface de pression D est plus petite que la surface de liaison V, **caractérisé en ce que** la pression d'adhérence peut être appliquée successivement sur des sections partielles de la surface de liaison V avec le moyen de transmission de pression.

2. Procédé selon la revendication 1, dans lequel la surface de pression D est < 80%, en particulier < 60%, de préférence < 40% de la surface de liaison V.

3. Procédé selon la revendication 1 ou 2, dans lequel la surface de pression D est mobile au moins partiellement, en particulier complètement, le long d'une surface d'application (2o, 2o') d'une des tranches (2, 3) détournée de la surface de liaison V.

4. Procédé selon l'une des revendications précédentes, dans lequel la pression d'adhérence peut être appliquée sur une section partielle de la surface de liaison V correspondant à la surface de pression D.

5. Procédé selon l'une des revendications précédentes, dans lequel la surface de pression peut recevoir au moins partiellement, en particulier complètement, des ultra-sons.

6. Procédé selon l'une des revendications précédentes, dans lequel la surface de pression D est mobile parallèlement à la surface d'application (2o, 2o'), en particulier de façon linéaire ou rotative.

7. Dispositif selon l'une des revendications précédentes, dans lequel la surface de pression D est cunéiforme.

8. Procédé selon l'une des revendications 1 à 6, dans lequel la surface de pression D est en forme de bande, en particulier avec des côtés longitudinaux (10) parallèles.

9. Procédé destiné à faire adhérer deux tranches (2, 3) sur une surface de liaison V des deux tranches (2, 3), dans lequel une pression d'adhérence est appliquée successivement sur des surfaces partielles de la surface de liaison V via un moyen de transmission de pression (1) avec une surface de pression D pour application sur les tranches (2, 3).
